# EUROPÄISCHE PATENTSCHRIFT

(11) **EP 1 362 020 B1**
(45) Veröffentlichungstag und Bekanntmachung des Hinweises auf die Patenterteilung: **11.03.2009**
(21) Anmeldenummer: 01990297.2
(22) Anmeldetag: 13.12.2001
(51) Int. Cl.: C04B 35/491

(54) **PIEZOELEKTRISCHES KERAMISCHES MATERIAL, VERFAHREN ZU DESSEN HERSTELLUNG UND ELEKTROKERAMISCHES MEHRLAGENBAUTEIL**
PIEZOELECTRIC CERAMIC MATERIAL, METHOD FOR PRODUCTION THEREOF AND ELECTROCERAMIC MULTI-LAYER COMPONENT
MATIERE CERAMIQUE PIEZO-ELECTRIQUE, PROCEDE DE PRODUCTION DE LADITE MATIERE ET COMPOSANT ELECTROCERAMIQUE A PLUSIEURS COUCHES

(30) Priorität: 12.01.2001 DE 10101188
(43) Veröffentlichungstag der Anmeldung: 19.11.2003
(73) Patentinhaber: ROBERT BOSCH GMBH, 70442 Stuttgart (DE)
(72) Erfinder: HAMMER, Marianne, 70563 Stuttgart (DE); KUEHLEIN, Marc, 70839 Gerlingen (DE); BOEDER, Horst, 86485 Biberach (DE)
(86) Internationale Anmeldenummer: PCT/DE2001/004694
(87) Internationale Veröffentlichungsnummer: WO 2002/055450

(56) Entgegenhaltungen:
- WO-A-97/40537
- WO-A-99/12865
- DE-A- 10 041 905
- DE-A- 19 840 488
- SHENG-YUAN CHU, CHENG-SUNG HSIEH: "Doping effects on the piezoelectric properties of low-temperature sintered PNN-PZT-based ceramics" JOURNAL OF MATERIAL SCIENCE LETTERS, Bd. 19, Nr. 7, 2000, Seiten 609-612, XP002198120
- SHROUT T R ET AL: "CONVENTIONALLY PREPARED SUBMICROMETER LEAD-BASED PEROVSKITE POWDERS BY REACTIVE CALCINATION" JOURNAL OF THE AMERICAN CERAMIC SOCIETY, AMERICAN CERAMIC SOCIETY. COLUMBUS, US, Bd. 73, Nr. 7, 1. Juli 1990 (1990-07-01), Seiten 1862-1867, XP000150668 ISSN: 0002-7820 in der Anmeldung erwähnt

## Beschreibung

Die Erfindung betrifft ein piezoelektrisches keramisches Material, ein Verfahren zu dessen Herstellung sowie ein elektrokeramisches Mehrlagenbauteil mit einem derartigen piezoelektrischen keramischen Material nach der Gattung der unabhängigen Ansprüche.

### Stand der Technik

Piezoelektrische Keramiken, die beispielsweise in Aktoren eingesetzt werden, sind häufig auf der Basis des Mischkristalles Bleizirkonattitanat (PZT) hergestellt und weisen bei Verwendung geeigneter Additive oder Dotierungen sehr gute Eigenschaftskombinationen wie eine hohe Temperaturbeständigkeit, eine hohe piezoelektrische Ladungskonstante, eine hohe Curie-Temperatur, eine niedrige Dielektrizitätskonstante und eine niedrige Koerzitivfeldstärke auf. Nachteilig ist jedoch, dass sich einige der maximal erreichbaren und gewünschten Eigenschaften dieser PZT-Keramiken bei Verwendung der bekannten Additive ausschließen.

Betrachtet man eine PZT-Struktur als eine A²⁺B⁴⁺O²⁻₃-Struktur, so bezeichnet man Keramiken, die eine A- oder B-Platz-Substitution durch ein höher valentes Kation (Donator) erfahren, als sogenannte "weiche Keramiken". Durch diese Substitution werden Blei-Leerstellen erzeugt, so dass solche Keramiken vor allem eine hohe piezoelektrische Ladungskonstante, eine hohe Dielektrizitätskonstante, einen hohen dielektrischen und mechanischen Verlust, eine niedrige Koerzitivfeldstärke und eine leichte Polarisierbarkeit aufweisen. Typische Additive, die diese Eigenschaften erzeugen sind beispielsweise zu A-Platz-Substitution La³⁺ bzw. allgemein Oxide der Seltenen Erden oder auch Bi³⁺. Zur B-Platz-Substitution kommt vor allem Ta⁵⁺, Nb⁵⁺, W⁶⁺ oder Sb⁵⁺ in Frage.

Demgegenüber bezeichnet man PZT-Keramiken, die eine A- oder B-Platz-Substitution durch ein nieder valentes Kation (Akzeptor) erfahren, als sogenannte "harte Keramiken". Hierbei werden Sauerstoff-Leerstellen erzeugt, so dass derartige Keramiken eine niedrige piezoelektrische Ladungskonstante, eine niedrige Dielektrizitätskonstante, einen niedrigen dielektrischen und mechanischen Verlust, eine hohe Koerzitivfeldstärke und einen niedrigen elektrischen Widerstand aufweisen. Weiter sind diese Keramiken in der Regel schwer polarisierbar. Typische Additive, die die genannten Eigenschaften in solchen "harten Keramiken" hervorrufen, sind zur A-Platz-Substitution beispielsweise K¹⁺ oder Na¹⁺. Als B-Platz-Substitution kommt vor allem Ni²⁺, Zn²⁺, Co²⁺, Fe³⁺, Sc³⁺ oder Mg²⁺ in Frage.

Zusammenfassend sind als PZT-Keramiken zur Anwendung in einem Piezoaktor vor allem solche Materialien relevant, die eine Kombination aus Eigenschaften der "weichen Keramiken" und "harten Keramiken" aufweisen. Insbesondere sollte die piezoelektrische Ladungskonstante und die Curie-Temperatur möglichst hoch, d.h. d₃₃ > 500 10¹² m/V und T_{c} > 300°C sein. Weiter sollte die Dielektrizitätskonstante des erhaltenen Materials möglichst niedrig, d.h. ε₃₃/ε₀ kleiner 2000 sein.

Zur Erreichung dieser Anforderungen wurde bereits vorgeschlagen, eine Kodotierung der PZT-Keramik vorzunehmen, die sowohl zur Bildung von Pb-Leerstellen als auch zur Bildung von Sauerstoff-Leerstellen führt. So wurde in DE 196 15 695 C1 vorgeschlagen, rein Donator-dotierte PZT-Grünfolien oberflächlich mit einer Agₓ/Pd₁₋ₓ-Paste (x = 0,7) zu versehen und diese zu stapeln, wobei bei einem nachfolgenden gemeinsamen Sintern der Grünfolie mit der Ag/Pd-Paste (Kofiring) das Silber in die benachbarten Keramikschichten eindiffundiert und als Akzeptor auf einem A-Platz eingebaut wird. Weiter wurde in EP 0 619 279 B1 vorgeschlagen, eine Dotierung mit komplexen Verbindungen der allgemeinen Formulierung A(B¹₁₋ₓB²ₓ) mit A = Pb und B¹ = einwertigen, zweiwertigen oder dreiwertigen Kationen und B² = dreiwertigen, fünfwertigen oder sechswertigen Kationen vorzunehmen, d.h. beispielsweise Verbindungen der Art A(W_{1/3}Ni_{2/3})O₃ oder A(Mg_{1/3}Nb_{2/3})O₃, wobei A Blei, Strontium, Calcium oder Barium sein kann.

Schließlich wurde in WO 99/12865 eine Dotierung einer PZT-Keramik mit bleifreien komplexen Verbindungen vorgeschlagen, die wie der PZT-Mischkristall eine Perowskitstruktur aufweisen, und die unter geringen Zugaben bei gemeinsamer Kalzinierung zu einem einphasigen Mischkristall reagieren. Solche Verbindungen weisen die allgemeine Zusammensetzung A²⁺ B¹_{0.25}¹⁺ B²_{0,75}⁵⁺ O₃ mit A = Barium und/oder Strontium, B¹ = Kalium und/oder Natrium und B² = Niob, Tantal oder Antimon, auf. Die erforderlichen Sintertemperaturen zur Herstellung eines elektrokeramischen Mehrlagenbauteils mit einem solchen piezoelektrischen keramischen Material liegen gemäß WO 99/12865 bei unter 1150°C.

Ferner sind aus SHENG-YUAN CHU, CHENG-SUNG HSIEH: "Doping effects on the piezoelectric properties of low-temperature sintered PNN-PZT-based ceramics" JOURNAL OF MATERIAL SCIENCE LETTERS, Bd. 19, Nr. 7, 2000, Seiten 609-612, XP002198120, WO 97/40537 A (SIEMENS AG; CRAMER DIETER (DE); HELLEBRAND HANS (DE); LUBITZ KARL) 30. Oktober 1997 (1997-10-30) und DE 198 40 488 A (CERAMTEC AG) 11. März 1999 (1999-03-11) verschiedene stöchiometrische PZT-Keramiken bekannt, die aber nicht die gewünschten Eigenschaften aufweisen.

Aufgabe der vorliegenden Erfindung war die Bereitstellung eines piezoelektrischen keramischen Materials mit möglichst hoher thermischer Stabilität, hoher piezoelektrischer Ladungskonstante und Curie-Temperatur sowie niedriger Dielektrizitätskonstante, niedrigen elektromechanischen Verlusten, einer niedrigen Koerzitivfeldstärke und einer niedrigen elektrischen Leitfähigkeit. Weiter war es Aufgabe, ein Material bereitzustellen, dass bei Temperaturen von unter 1000°C gesintert werden kann, damit bei der Herstellung elektrokeramischer Mehrlagenbauteile mit diesem Material eine preiswertere Innenelektroden-Paste zum Einsatz kommen kann als die bisher übliche.

### Vorteile der Erfindung

Das erfindungsgemäße piezoelektrische keramische Material hat gegenüber dem Stand der Technik den Vorteil einer hohen thermischen Stabilität, einer piezoelektrischen Ladungskonstante d₃₃ größer 500 10¹² m/V, einer Curie-Temperatur T_{c} größer 300°C, einer Dielektrizitätskonstante ε₃₃/ε₀ kleiner 2000 und einer Koerzitivfeldstärke kleiner 1,2 kV/mm bei geringen elektromechanischen Verlusten und einer niedrigen elektrischen Leitfähigkeit auf. Weiter ist dieses piezoelektrische keramische Material beispielsweise zusammen mit Elektrodenpastenschichten auf Basis von Kupfer oder Agₜ/Pd₁₋ₜ mit t ≥ 0,7, wobei t für den Massenanteil steht, bei Temperaturen von weniger als 1000°C in einem Kofiring-Prozess zu einem elektromechanischen Mehrlagenbauteil sinterbar, wobei dieses Sintern zusätzlich vorteilhaft unter Luft, Stickstoff oder stickstoffhaltiger Gasatmosphäre stattfinden kann.

Insbesondere ermöglicht es diese niedrige Sintertemperatur, als Material für die Elektrodenpastenschichten ein Silber-Palladium-Gemisch einzusetzen, dessen Silbergehalt deutlich über 70 Massenprozent liegt und das billiger ist als Innenelektrodenmaterialien auf Platin-Basis bzw. Innenelektroden mit höherem Palladium-Anteil.

Auch die der Verwendung edelmetallfreier Elektrodenpastenschichten bzw. edelmetallfreier Pasten wie beispielsweise Kupfer-Pasten bietet erhebliche Kostenvorteile, wobei durch Zusatz von Kupferoxid zu dem piezoelektrischen keramischen Material als Additiv- bzw. Dotierstoff gleichzeitig eine unerwünschte Diffusion von Kupfer aus den Innenelektrodenschichten in das benachbarte keramische Material verhindert werden kann. In diesem Fall ist durch den Kupferoxid-Zusatz zu der PZT-Keramik bereits eine Sättigung mit Kupfer-Ionen gegeben. Im Übrigen verringert die Möglichkeit Kupfer alternativ zu Silber/Palladium einzusetzen die Abhängigkeit des Preises der erhaltenen elektrokeramischen Mehrlagenbauteile von dem hochspekulativen Palladium-Preis bzw. Platin-Preis.

Bei dem erfindungsgemäßen Verfahren zur Herstellung des piezoelektrischen keramischen Materials ist vorteilhaft, dass alle neben Blei, Zirkonium und Titan eingesetzten Additive bzw. Dotierstoffe als pulverförmige Oxide oder Carbonate eingesetzt werden können, die kostengünstig und in großen Mengen verfügbar sind.

Vorteilhafte Weiterbildungen der Erfindung ergeben sich aus den in den Unteransprüchen genannten Maßnahmen.

So ist vorteilhaft, dem piezoelektrischen keramischen Material als ein Dotierungselement Kupfer in Form eines Cu¹⁺-und/oder Cu²⁺-Ions zuzusetzen, das dies ein Sintern von keramischen Grünfolien, denen dieses Material als keramischer Bestandteil zugesetzt ist, zusammen mit einer kupferhaltigen Elektrodenpastenschicht unter Luft, Stickstoff oder stickstoffhaltiger Atmosphäre ermöglicht.

Im Übrigen kann das erhaltene piezoelektrische Material vorteilhaft sowohl eine stöchiometrische Zusammensetzung aufweisen als auch eine Zusammensetzung, die ein Bleioxid, insbesondere PbO, im stöchiometrischen Überschuss enthält, was zu einer weiteren Erniedrigung der Sintertemperatur führt.

Darüber hinaus ist es einfach in bekannter Weise zu einem gießfähigen Schlicker oder einer extrusionsfähigen Masse zur Herstellung keramischer Grünfolien verarbeitbar.

### Ausführungsbeispiele

Die Erfindung geht aus von einem piezoelektrischen Keramikmaterial auf der Basis von Bleizirkonattitanat (PZT) mit der allgemeinen Zusammensetzung A²⁺B⁴⁺O²⁻₃, das mit einer Kodotierung mit Donatoren und Akzeptoren versehen ist. Diese Kodotierung wird durch Zusatz von pulverförmigen Oxiden und/oder pulverförmigen Carbonaten mit entsprechenden Metall-Ionen erreicht und erfolgt sowohl auf den A²⁺-Plätzen als auch auf den B⁴⁺-Plätzen der PZT-Keramik. Auf diese Weise bleibt durch eine Ladungskompensation der Bleileerstellen und der Sauerstoffleerstellen die gesamte Defektkonzentration in dem erhaltenen piezoelektrischen keramischen Material gering, was die Stabilität von dessen Struktur und damit die piezoelektrische Aktivität und thermische Stabilität erhöht. Im stöchiometrischen Fall lautet die allgemeine Formulierung des piezoelektrischen keramischen Materials:

Pb_{1-x-(3/2a)-1/2(x·b)} A¹ₓ A²ₐ (Zr_{y(1-x·b-x·z)} Ti_{(1-y)(1-x·b-x·w)}) (B¹_{b} B²_{z} B³_{w})ₓ O₃

wobei A¹ aus der Gruppe Ca, Mg, Sr, Ba oder deren Mischungen ausgewählt ist, A² aus der Gruppe der Seltenen Erden, insbesondere La, oder deren Mischungen ausgewählt ist, B¹ aus der Gruppe Nb, Ta oder Sb oder deren Mischungen ausgewählt ist, B² Cu oder eine Mischung von Cu mit mindestens einem Element ausgewählt aus der Gruppe Zn, Ni, Co oder Fe ist, und B³ Fe ist, mit der Maßgabe, dass für a, b, c, x, y, z und w gilt:
0,001 ≤ a ≤ 0,05
0,05 ≤ b ≤ 0,90
0,005 ≤ x ≤ 0,03
0,5 ≤ y ≤ 0,55
0,05 ≤ z ≤ 0, 90
0 ≤ w ≤ 0,5.

Die Zahlenangaben für a, b, x, y, z und w sind dabei jeweils in Mol zu verstehen.

Alternativ zu der vorstehenden Zusammensetzung kann beispielsweise auch ein Bleioxid, insbesondere PbO, im stöchiometrischen Überschuss zugesetzt sein, so dass das erhaltene piezoelektrische keramische Material insgesamt eine nicht stöchiometrische Zusammensetzung aufweist. In diesem Fall lautet die allgemeine Formulierung des piezoelektrischen keramischen Materials:

Pb_{(1+c)-x-(3/2a)-1/2(x-b)} A¹ₓ A²ₐ (Zr_{y(1-x·b-x·z)} Ti_{(1-y)(1-x·b-x·w)}) (B¹_{b} B²_{z} B³_{w})ₓ O₃

mit A¹, A², B¹ B² und B³ wie vorstehend und der Maßgabe, dass für a, b, c, x, y, z und w gilt:
0,001 ≤ a ≤ 0,05
0,05 ≤ b ≤ 0,90
0 ≤ c ≤ 0,04
0,005 ≤ x ≤ 0,03
0,5 ≤ y ≤ 0,55
0,05 ≤ z ≤ 0, 90
0 ≤ w ≤ 0,5.

Im stöchiometrischen Fall gilt somit für das erhaltene piezoelektrische keramische Material die Bedingung c = 0, während im nicht stöchiometrischen Fall für c die Bedingung 0,005 ≤ c ≤ 0,04 gilt.

Ein bevorzugtes piezoelektrisches keramisches Material, das sich besonders für eine Anwendung in Piezoaktoren eignet, ist ein Material der Formulierung:

Pb_{(1-x)-(3/2a)-1/2(x·b)} Caₓ Laₐ (Zr_{y(1-x·b-x·z)} Ti_{(1-y)}(_{1-x·b-x·w)}) (Nb_{b} Cu_{z} Fe_{w})ₓ O₃

mit:
0,0025 ≤ a ≤ 0,01
0,5 ≤ b ≤ 0,9
0,01 ≤ x ≤ 0,025
0,05 ≤ w ≤ 0,3
0,51 ≤ y(1-(x·b)-(x·z)) ≤ 0,55
0,45 ≤ (1-y)(1-(x·b)-(x·w)) ≤ 0,49
0,05 ≤ w ≤ 0,3.

An dieser Stelle sei betont, dass der Anteil des Sauerstoffs in allen vorstehenden Formulierungen des piezoelektrischen keramischen Materials durch eingebrachte oder beim Sintern erzeugte Sauerstoffleerstellen in der Regel nicht exakt durch O₃ sondern präziser durch O_{3-δ} zu beschreiben ist, wobei δ kleiner als 0,01, insbesondere kleiner als 0,004 ist. Da die Bildung von Sauerstoffleerstellen bei derartigen Materialien stets auftritt, und innerhalb der genannten Grenzen nicht präzise messbar ist, wird im Rahmen dieser Patentanmeldung unter der Formulierung

Pb_{(1+c)-x-(3/2a)-1/2(x·b)} A¹ₓ A²ₐ (Zr_{y(1-x·b-x·z)} Ti_{(1-y)(1-x·b-x·w)}) (B¹_{b} B²_{z} B³_{w})ₓ O₃

in Übereinstimmung mit dem allgemeinen Fachverständnis auch ein Material verstanden, das Sauerstoffleerstellen innerhalb der genannten Grenzen aufweist.

Konkrete Beispiele für die von den vorgenannten Formulierungen erfassten Materialien sind:
Pb_{0,965} Ca_{0,02} La_{0,005} Zr_{0,5194} Ti_{0,4606} Nb_{0,015} Fe_{0,003} Cu_{0,002} O_{3-δ} mit x = 0, 02, a = 0, 005, y = 0, 53, b = 0,75, z = 0,1, c = 0 und w = 0,15 sowie δ kleiner 0,004.
Pb_{0,9685} Ca_{0,02} La_{0,002} Zr_{0,5194} Ti_{0,4606} Nb_{0,017} Fe_{0,002} Cu_{0,001} O_{3-δ} mit x = 0,02, a = 0,002, y = 0,53, b = 0,85, z = 0,05; c = 0 und w = 0,1 sowie δ kleiner 0,004.
Pb_{0,9687} Ca_{0,02} La_{0,0025} Zr_{0,5194} Ti_{0,4606} Nb_{0,015} Zn_{0,002} Co_{0,002} Cu_{0,001} O_{3-δ} mit x = 0,02, a = 0,0025, y = 0,53, b = 0,75, z = 0,25, c = 0 und w = 0 sowie δ kleiner 0,004.
Pb_{0,9678} Ca_{0,018} La_{0,005} Zr_{0,5203} Ti_{0,4614} Nb_{0,0135} Zn_{0,003} Cu_{0,0018} O_{3-δ} mit x = 0,02, a = 0,0025, y = 0,53, b = 0,75, z = 0,25, c = 0 und w = 0 sowie δ kleiner 0,004.
Pb_{0,9978} Ca_{0,018} La_{0,005} Zr_{0,5203} Ti_{0,4614} Nb_{0,0135} Zn_{0,003} Cu_{0,0018} O_{3-δ} mit x = 0,02, a = 0, 0025, y = 0,53, b = 0,75, z = 0,25; c = 0,03 und w = 0 sowie δ kleiner 0,004.
Pb_{0,9878} Ca_{0,02} La_{0,0025} Zr_{0,2} Ti_{0,46} Nb_{0,015} Zn_{0,002} Co_{0,002} Cu_{0,001} O_{3-δ} mit x = 0,02, a = 0, 0025, y = 0, 53, b = 0,75, z = 0,25, c = 0,02 und w = 0 sowie δ kleiner 0,004.

Zur Weiterverarbeitung eines solchen piezoelektrischen keramischen Materials zu einem elektrokeramischen Mehrlagenbauteil, insbesondere einem Piezoaktor, einem Thermistor oder einem Kondensator, mit einer Mehrzahl von übereinander angeordneten Isolierschichten aus dem piezoelektrischen keramischen Material und bereichsweise dazwischen befindlichen Innenelektrodenschichten, die zumindest weitgehend aus Kupfer oder Agₜ/Pd₁₋ₜ bestehen, wobei t ≥ 0, 7, insbesondere > 0, 7, vorzugsweise > 0,8 ist, wird zunächst eines der vorstehend beschriebenen Materialien in bekannter Weise zu einem gießfähigen Schlicker bzw. zu einer extrusionsfähigen Masse verarbeitet und danach entweder mittels Foliengießen oder Extrusion zu einer Grünfolie geformt, getrocknet und in üblicher Weise oberflächlich bereichsweise mit einer Schicht einer leitfähigen Innenelektrodenpaste versehen. Diese Innenelektrodenpaste ist bevorzugt eine Paste auf Basis von Kupfer oder einer der beschriebenen Silber-Palladium-Mischungen.

Nachdem die keramischen Grünfolien, die beispielsweise eine Dicke von 30 µm bis 150 µm aufweisen, mit der leitfähigen Innenelektrodenpaste bedruckt worden sind, werden sie gestanzt, gestapelt und laminiert, wobei die Schichtzahl der Isolierschichten mit dem piezoelektrischen keramischen Material üblicherweise zwischen 10 und 500 Schichten liegt. Nach dem Laminieren folgt dann ein bekannter Kofiring-Prozess unter Luft, Stickstoff oder stickstoffhaltiger Gasatmosphäre bei Sintertemperaturen unter 1000°C.

Bei diesem Sintern entstehen aus den keramischen Grünfolien die Isolierschichten und aus den Elektrodenpastenschichten die Innenelektrodenschichten des elektrokeramischen Mehrlagenbauteils, das danach als dichter Keramik-Elektroden-Verbund vorliegt und beispielsweise nach Anbringen einer Außenkontaktierung der Innenelektroden als Piezoaktor verwendbar ist. Beim Sintern werden im Übrigen die Elektrodenpastenschichten in metallische Innenelektrodenschichten überführt, die zumindest dann weitgehend entweder aus Kupfer oder der beschriebenen Silber-Palladium-Legierung bestehen.

Als Verfahren zur Herstellung der vorstehend beschriebenen piezoelektrischen keramischen Materialien eignet sich einerseits die sogenannte "Columbitmethode", wie sie von T.R. Shrout et al., J. Am. Ceram. Soc., 73, (7), Seiten 1862 - 1867, (1990), beschrieben ist. Im Einzelnen werden dabei zunächst pulverförmiges Zirkoniumdioxid und pulverförmiges Titandioxid zu Zr_{y}Ti_{1-y}O₂ mit 0,5 < y < 0,55 (Angabe in Mol) kalziniert, das erhaltene Zr_{y}Ti_{1-y}O₂ zu einem Pulver aufbereitet, dieses im Weiteren als Precursor dienende Pulver dann mit pulverförmigen Oxiden und/oder pulverförmigen Carbonaten der weiteren Ionen Blei, Eisen, A¹, A², B² und B² vermischt, und diese Pulvermischung dann zu dem piezoelektrischen keramischen Material in Form eines homogenen PZT-Mischkristalles kalziniert. Alternativ kann als Herstellungsverfahren auch ein "mixed-oxide"-Verfahren eingesetzt werden, d.h. es werden zunächst alle in das herzustellende piezoelektrische keramische Material einzusetzenden Ionen als pulverförmige Oxide und/oder pulverförmige Carbonate eingesetzt, miteinander vermischt und dann zu dem piezoelektrischen keramischen Material kalziniert. Die einzusetzenden Mengen der jeweiligen Oxide bzw. Carbonate ergeben sich dabei aus der zu erhaltenden Zusammensetzung des piezoelektrischen keramischen Materials.

## Patentansprüche

1. Piezoelektrisches keramisches Material mit der, abgesehen von Sauerstoffleerstellen, molaren Zusammensetzung:
Pb_{(1+c)-x-(3/2a)-1/2(x·b)} A¹ₓ A²ₐ (Zr_{y(1-x·b-x·z)} Ti_{(1-y)(1-x·b-x·w)}) (B¹_{b} B²_{z} B³_{w})ₓ O₃
wobei A¹ aus der Gruppe Ca, Mg, Sr, Ba oder deren Mischungen ausgewählt ist, A² aus der Gruppe der Seltenen Erden, insbesondere La, oder deren Mischungen ausgewählt ist, B¹ aus der Gruppe Nb, Ta oder Sb oder deren Mischungen ausgewählt ist, B² Cu oder eine Mischung von Cu mit mindestens einem Element ausgewählt aus der Gruppe Zn, Ni, Co oder Fe ist, und B³ Fe ist, mit der Maßgabe, dass für a, b, c, x, y, z und w gilt:
0,001 ≤ a ≤ 0, 05
0,05 ≤ b ≤ 0,90
0 ≤ c ≤ 0,04
0,005 ≤ x ≤ 0,03
0,5 ≤ y ≤ 0,55
0,05 ≤ z ≤ 0,90
0 ≤ w ≤ 0,5.

2. Piezoelektrisches keramisches Material nach Anspruch 1, **dadurch gekennkennzeichnet, dass** 0,005 ≤ c ≤ 0,04.

3. Piezoelektrisches Material nach Anspruch 1, **dadurch gekennzeichnet, dass** c = 0.

4. Piezoelektrisches Material nach einem der vorangehenden Ansprüche, **dadurch gekennzeichnet, dass** A¹ ein zweiwertiges Ion, A² ein dreiwertiges Ion, B¹ ein fünfwertiges Ion, B² ein einwertiges Ion, ein zweiwertiges Ion oder eine Mischung aus mindestens einem einwertigen Ion und mindestens einem zweiwertigen Ion, und B³ ein dreiwertiges Fe-Ion ist.

5. Piezoelektrisches keramisches Material nach einem der vorangehenden Ansprüche, wobei c = 0, A¹ Ca, A² La, B¹ Nb und B² Cu ist.

6. Piezoelektrisches Material nach Anspruch 5, **dadurch gekennzeichnet, dass** für a, b, x, y, z und w gilt:
0,0025 ≤ a ≤ 0,01
0,5 ≤ b ≤ 0,9
0,01 ≤ x ≤ 0,025
0,05 ≤ w ≤ 0,3
0,51 ≤ y(1-(x·b)-(x·z)) ≤ 0,55
0,45 ≤ (1-y)(1-(x·b)-(x·w)) ≤ 0,49
0,05 ≤ w ≤ 0,3.

7. Elektrokeramisches Mehrlagenbauteil, insbesondere Piezoaktor, Thermistor oder Kondensator, mit einer Mehrzahl von übereinander angeordneten Isolierschichten mit einem piezoelektrischen keramischen Material nach einem der vorangehenden Ansprüche 1 bis 6, die zumindest bereichsweise durch oberflächlich aufgebrachte Innenelektrodenschichten voneinander getrennt sind.

8. Elektrokeramisches Mehrlagenbauteil nach Anspruch 7, **dadurch gekennzeichnet, dass** die Innenelektrodenschichten zumindest weitgehend aus Kupfer oder Agₜ/Pd₁₋ₜ bestehen, wobei t ≥ 0,7, insbesondere t > 0,7 ist und für den Massenanteil steht.

9. Elektrokeramisches Mehrlagenbauteil nach Anspruch 8, **dadurch gekennzeichnet, dass** es durch Sintern eines Stapels mit keramischen Grünfolien mit einem piezoelektrischen keramischen Material nach einem der Ansprüche 1 bis 6, die zumindest bereichsweise oberflächlich durch Elektrodenpastenschichten mit Kupfer oder Agₜ/Pd₁₋ₜ mit t ≥ 0,7 voneinander getrennt sind, bei Temperaturen unter 1000°C in einem Kofiring-Prozess hergestellt worden ist, wobei aus den keramischen Grünfolien die Isolierschichten und aus den Elektrodenpastenschichten die Innenelektrodenschichten entstanden sind.

10. Verfahren zur Herstellung eines piezoelektrischen keramischen Materials nach einem der Ansprüche 1 bis 6, wobei die Ionen Pb, Zr, Ti, Fe, A¹, A², B¹ und B² zunächst als pulverförmige Oxide und/oder Carbonate eingesetzt, miteinander vermischt und dann zu dem keramischen Material kalziniert werden.

11. Verfahren nach Anspruch 10, wobei ein Bleioxid, insbesondere PbO, im stöchiometrischen Überschuss eingesetzt wird.

12. Verfahren nach Anspruch 10, wobei die eingesetzten pulverförmigen Oxide und/oder Carbonate derart eingesetzt werden, dass das piezoelektrische keramische Material eine stöchiometrische Zusammensetzung aufweist.

13. Verfahren zur Herstellung eines piezoelektrischen keramischen Materials nach einem der Ansprüche 1 bis 6, wobei zunächst pulverförmiges ZrO₂ und pulverförmiges TiO₂ zu Zry-Ti_{1-y}O₂ mit 0,50 < y < 0,55 kalziniert, das Zr_{y}Ti_{1-y}O₂ zu einem Pulver aufbereitet, dieses Pulver mit pulverförmigen Oxiden und/oder pulverförmigen Carbonaten der Ionen Pb, Fe, A¹, A², B¹, B² vermischt, und diese Pulvermischung dann zu dem keramischen Material kalziniert wird.

14. Verfahren nach Anspruch 13, wobei ein Bleioxid, insbesondere PbO, im stöchiometrischen Überschuss eingesetzt wird.

15. Verfahren nach Anspruch 13, wobei die eingesetzten pulverförmigen Oxide und/oder Carbonate derart eingesetzt werden, dass das piezoelektrische keramische Material eine stöchiometrische Zusammensetzung aufweist.

## Claims

1. Piezoelectric ceramic material which has, apart from oxygen vacancies, the following molar composition:
Pb_{(1+c)-x-(3/2a)-1/2(x·b)}A¹ₓA²ₐ(Zr_{y(1-x·b-x·z)}Ti_{(1-y)(1-x·b-x·w)}) (B¹_{b}B²_{z}B³_{w})ₓO₃
where A¹ is selected from the group consisting of Ca, Mg, Sr, Ba or mixtures thereof, A² is selected from the group consisting of the rare earth elements, in particular La, or mixtures thereof, B¹ is selected from the group consisting of Nb, Ta or Sb or mixtures thereof, B² is Cu or a mixture of Cu with at least one element selected from the group consisting of Zn, Ni, Co or Fe, and B³ is Fe, with the proviso that the following applies for a, b, c, x, y, z and w:
0.001 ≤ a ≤ 0.05
0.05 ≤ b ≤ 0.90
0 ≤ c ≤ 0.04
0.005 ≤ x ≤ 0.03
0.5 ≤ y ≤ 0.55
0.05 ≤ z ≤ 0.90
0 ≤ w ≤ 0.5.

2. Piezoelectric ceramic material according to Claim 1, **characterized in that** 0.005 ≤ c ≤ 0.04.

3. Piezoelectric material according to Claim 1,
**characterized in that** c = 0.

4. Piezoelectric material according to one of the preceding claims, **characterized in that** A¹ is a divalent ion, A² is a trivalent ion, B¹ is a pentavalent ion, B² is a monovalent ion, a divalent ion or a mixture of at least one monovalent ion and at least one divalent ion, and B³ is a trivalent Fe ion.

5. Piezoelectric ceramic material according to one of the preceding claims, wherein c = 0, A¹ is Ca, A² is La, B¹ is Nb and B² is Cu.

6. Piezoelectric material according to Claim 5,
**characterized in that** the following applies for a, b, x, y, z and w:
0.0025 ≤ a ≤ 0.01
0.5 ≤ b ≤ 0.9
0.01 ≤ x ≤ 0.025
0.51 ≤ y(1-(x·b)-(x·z)) ≤ 0.55
0.45 ≤ (1-y)(1-(x·b)-(x·w)) ≤ 0.49
0.05 ≤ w ≤ 0.3.

7. Electroceramic multilayer component, in particular piezo actuator, thermistor or capacitor, comprising a plurality of superimposed insulating layers which have a piezoelectric ceramic material according to one of the preceding Claims 1 to 6 and are separated from one another at least in certain regions by superficially applied inner electrode layers.

8. Electroceramic multilayer component according to Claim 7, **characterized in that** the inner electrode layers at least largely consist of copper or Agₜ/Pd₁₋ₜ, with t ≥ 0.7, in particular t > 0.7 and being the mass fraction.

9. Electroceramic multilayer component according to Claim 8, **characterized in that** it has been produced by using a cofiring process at temperatures of below 1000°C to sinter a stack comprising ceramic green sheets which have a piezoelectric ceramic material according to one of Claims 1 to 6 and are separated from one another on the surface at least in certain regions by electrode paste layers containing copper or Agₜ/Pd₁₋ₜ with t ≥ 0.7, wherein the insulating layers are produced from the ceramic green sheets and the inner electrode layers are produced from the electrode paste layers.

10. Process for producing a piezoelectric ceramic material according to one of Claims 1 to 6, wherein the ions Pb, Zr, Ti, Fe, A¹, A², B¹ and B² are initially used as pulverulent oxides and/or carbonates, are mixed with one another and are then calcined to form the ceramic material.

11. Process according to Claim 10, wherein a stoichiometric excess of a lead oxide, in particular PbO, is used.

12. Process according to Claim 10, wherein the pulverulent oxides and/or carbonates which are used are employed in such a manner that the piezoelectric ceramic material has a stoichiometric composition.

13. Process for producing a piezoelectric ceramic material according to one of Claims 1 to 6, wherein pulverulent ZrO₂ and pulverulent TiO₂ are initially calcined to form Zr_{y}Ti_{1-y}O₂ where 0.50 < y < 0.55, the Zr_{y}Ti_{1-y}O₂ is processed to form a powder, this powder is mixed with pulverulent oxides and/or pulverulent carbonates of the ions Pb, Fe, A¹, A², B¹, B², and this powder mixture is then calcined to form the ceramic material.

14. Process according to Claim 13, wherein a stoichiometric excess of a lead oxide, in particular PbO, is used.

15. Process according to Claim 13, wherein the pulverulent oxides and/or carbonates which are used are employed in such a manner that the piezoelectric ceramic material has a stoichiometric composition.

## Revendications

1. Matériau céramique piézoélectrique qui, compte non tenu des sites inoccupés par l'oxygène, a la composition molaire suivante :
Pb_{(1+c)-x-(3/2a)-1/2-(x.b)}A¹ₓA²ₐ(Zr_{y(1-x.b-x.z)}Ti_{(1-y)(1-x.b-x.w)} (B¹_{b}B²_{z}B³_{w})ₓO₃
dans laquelle A¹ est sélectionné dans l'ensemble constitué de Ca, Mg, Sr, Ba et de leurs mélanges, A² dans l'ensemble constitué des terres rares, en particulier La, et de leurs mélanges, B¹ est sélectionné dans l'ensemble constitué de Nb, Ta, Sb et de leurs mélanges, B² représente Cu ou un mélange de Cu avec au moins un élément sélectionné dans l'ensemble constitué de Zn, Ni, Co et Fe et B³ représente Fe, avec la condition que a, b, c, x, y, z et w sont régis par :
0,001 ≤ a ≤ 0,05
0,05 ≤ b ≤ 0,90
0 ≤ c ≤ 0,04
0,005 ≤ x ≤ 0,03
0,5 ≤ y ≤ 0,55
0,05 ≤ z ≤ 0,90
0 ≤ w ≤ 0,5.

2. Matériau céramique piézoélectrique selon la revendication 1, **caractérisé en ce que**
0,005 ≤ c ≤ 0,04.

3. Matériau piézoélectrique selon la revendication 1, **caractérisé en ce que** c = 0.

4. Matériau piézoélectrique selon l'une des revendications précédentes, **caractérisé en ce que** A¹ représente un ion divalent, A² un ion trivalent, B¹ un ion pentavalent, B² un ion monovalent, un ion divalent ou un mélange d'au moins un ion monovalent et d'au moins un ion divalent et B³ représente un ion trivalent de Fe.

5. Matériau céramique piézoélectrique selon l'une des revendications précédentes, dans lequel c = 0, A¹ représente Ca, A² représente La, B¹ représente Nb et B² représente Cu.

6. Matériau piézoélectrique selon la revendication 5, **caractérisé en ce que** a, b, x, y, z et w sont régis par :
0,0025 ≤ a ≤ 0,01
0,5 ≤ b ≤ 0,9
0,01 ≤ x ≤ 0,025
0,51 ≤ y(1-(x.b)-(x.z) ≤ 0,55
0,45 ≤ (1-y)(1-(x.b)-(x.w) ≤ 0,49
0,05 ≤ w ≤ 0,3.

7. Composant électrocéramique multicouches, en particulier piézoactionneur, thermistor ou condensateur, qui présente plusieurs couches isolantes disposées les unes au-dessus des autres, qui présentent d'un matériau céramique piézoélectrique selon l'une des revendications 1 à 6 qui précèdent et qui sont séparées au moins partiellement les unes des autres par des couches d'électrodes intérieures appliquées en surface.

8. Composant électrocéramique multicouches selon la revendication 7, **caractérisé en ce que** les couches d'électrodes intérieures sont constituées au moins largement de cuivre ou d'Agₜ/Pd₁₋ₜ avec t ≥ 0,7 et en particulier t > 0,7, t représentant la proportion massique.

9. Composant électrocéramique multicouches selon la revendication 8, **caractérisé en ce qu'**il a été préparé par frittage d'un empilement de feuilles céramiques crues qui présentent un matériau céramique piézoélectrique selon l'une des revendications 1 à 6 et qui sont séparées au moins partiellement les unes des autres en surface par des couches de pâte d'électrode qui contiennent du cuivre ou Agₜ/Pd₁₋ₜ avec t ≥ 0,7, à une température inférieure à 1 000°C dans le procédé dit "Kofiring", les couches isolantes étant formées à partir des feuilles céramiques crues et les couches d'électrodes intérieures à partir des couches de pâte d'électrode.

10. Procédé de fabrication d'un matériau céramique piézoélectrique selon l'une des revendications 1 à 6, dans lequel les ions Pb, Zr, Ti, Fe, A¹, A², B¹ et B² sont d'abord utilisés sous la forme d'oxydes et/ou de carbonates pulvérulents et sont mélangés ensemble pour ensuite être calcinés en vue de former le matériau céramique.

11. Procédé selon la revendication 10, dans lequel on utilise un oxyde de plomb, en particulier le PbO, en excès stoechiométrique.

12. Procédé selon la revendication 10, dans lequel les oxydes et/ou carbonates pulvérulents sont utilisés de telle sorte que le matériau céramique piézoélectrique présente une composition stoechiométrique.

13. Procédé de fabrication d'un matériau céramique piézoélectrique selon l'une des revendications 1 à 6, dans lequel on calcine d'abord du ZrO₂ pulvérulent ou du TiO₂ pulvérulent en Zr_{y}Ti_{1-y}O₂ avec 0,50 < y < 0,55, on transforme le Zr_{y}Ti_{1-y}O₂ en une poudre, on mélange cette poudre avec des oxydes et/ou carbonates pulvérulents des ions Pb, Fe, A¹, A², B² et B² on calcine ensuite ce mélange de poudres pour obtenir le matériau céramique.

14. Procédé selon la revendication 13, dans lequel on utilise un oxyde de plomb, en particulier le PbO, en excès stoechiométrique.

15. Procédé selon la revendication 13, dans lequel les oxydes et/ou carbonates pulvérulents sont utilisés de telle sorte que le matériau céramique piézoélectrique présente une composition stoechiométrique.
